# EUROPEAN PATENT APPLICATION

(11) **EP 1 783 827 A1**
(43) Date of publication of application: **09.05.2007**
(21) Application number: 05743795.6
(22) Date of filing: 26.05.2005
(51) Int. Cl.: H01L 21/52, B23K 35/26

(54) **SOLDERING METHOD, SOLDER PELLET FOR DIE BONDING, METHOD FOR MANUFACTURING SOLDER PELLET FOR DIE BONDING AND ELECTRONIC COMPONENT**

(30) Priority: 01.06.2004 JP 2004163062
(71) Applicant: SENJU METAL INDUSTRY CO., LTD., Tokyo, 120-8555 (JP)
(72) Inventor: UESHIMA, Minoru, 2700021 (JP)
(74) Representative: Schrimpf, Robert
(86) International application number: PCT/JP2005/009630
(87) International publication number: WO 2005/119755

(57) **Abstract**

A pellet for use in die bonding of an electronic chip and a substrate in an electronic component generates minimized voids in spite of the pellet being made of a lead-free solder. The pellet forms a colorless transparent protective film comprising Sn-(30 - 50 at % O) -(5 - 15 at % P) or Sn-(10 - 30 at % In)-(40 - 60 at % O)-(5 - 15 at % P) when heated for soldering, has a thickness of 0.05 - 1 mm, and has generally the same shape as the semiconductor chip to be bonded to the substrate.

## Description

### Technical Field

This invention relates to a solder pellet for die bonding (bare bonding) which is used to join a semiconductor chip or element and a substrate to each other in an electronic component and to an electronic component comprising a semiconductor chip and a substrate bonded to each other by solder.

### Background Art

High performance electronic components such as BGA's and CSP's have a semiconductor chip and a substrate which are joined to each other by die bonding with a bonding material. Die bonding refers to a process in which a semiconductor chip obtained from a silicon wafer by cutting is secured to a substrate of an electronic component. During the use of electronic equipment, a semiconductor chip generates heat, and the semiconductor itself may suffer a degradation in performance or undergo thermal damage due to the effect of this heat. Therefore, die bonding of a semiconductor chip and a substrate is carried out for the purpose of dissipating the heat generated by the semiconductor chip through the substrate by bonding the semiconductor chip to the substrate. Another purpose of die bonding is to electrically ground a semiconductor chip. A material which is typically used for die bonding is an adhesive resin or solder. An adhesive resin is adequate if die bonding is only required to dissipate heat from the semiconductor chip, but when both heat dissipation and electrical grounding are desired, solder having good thermal conductivity and good electrical conductivity is used for die bonding.

In die bonding for the purpose of heat dissipation, ideally the semiconductor chip and the substrate are perfectly bonded to each other without any vacant spaces (voids) in the bond area. When bonding is performed with an adhesive resin, if there are small air bubbles in the adhesive resin, the bubbles are pressed together and form large voids. Therefore, when using an adhesive resin, in order to remove bubbles from the resin, deaeration treatment is carried out in which the adhesive resin is stirred in a vacuum to allow any bubbles in the resin to escape. In the case of bonding with solder, the formation of voids is caused by flux used for soldering. The flux gasifies when heated for soldering, and if the gasified flux remains in the resulting soldered portion, it forms voids therein. In addition, if a solder having poor wettability is used, some portions to be bonded may not wet by molten solder during soldering and result in the formation of voids.

Flux is typically used in soldering. However, when flux is used, flux residue remains. Flux residue may absorb moisture and form corrosive substances, and it may cause a decrease in insulating resistance. Therefore, for electronic equipment requiring high reliability, soldering which does not use flux, i.e., fluxless soldering is employed. In fluxless soldering, after solder is placed on a portion to be soldered, the solder is heated in a mixed gas atmosphere containing hydrogen and nitrogen. When fluxless soldering is carried out, the formation of voids due to gasification of flux is no longer a problem, but wettability of solder greatly affects soldering performance. In soldering with flux, the flux serves to remove oxides from portions to be soldered by reduction and also lower the surface tension of molten solder, so the solder can wet and spread out well. However, when die bonding is performed by fluxless soldering, the mixed gas atmosphere cannot provide as strong an activity as can flux. Accordingly, when die bonding is carried out by fluxless soldering, it is necessary to use a solder which itself has good wettability.

The present applicant disclosed solder preforms, such as solder pellets for die bonding, which are uniformly coated on their surfaces with a substance which is solid at room temperature so that the solder preforms will not adhere to each other (Patent Document 1).
Patent Document 1: JP 09-29478 A

### Disclosure of the Invention

### Problem Which the Invention is to Solve

In the past, solder which was used for die bonding was Sn-Pb based solder. However, due to the problem of lead pollution, the use of Sn-Pb based solder has come to be restricted, and today, so-called lead-free solder which does not contain lead has come to be used. Lead-free solder is made of Sn or has Sn as a main component to which additional element or elements such as Ag, Cu, Sb, Bi, In, Ni, Cr, Mo, Ge, Ga, P, or the like are suitably added. A Sn-Pb based solder has good wettability and forms few voids even if it is used for die bonding without a flux. However, a lead-free solder has inferior wettability compared to a Sn-Pb based solder, and many voids are formed when it is used for die bonding without a flux. If a large amount of voids is formed during die bonding with solder, not only does heat dissipation become poor, but also the bonding strength decreases, and when the entire substrate undergoes repeated expansion and contraction by the heat that is electrically generated during use of a product, the decreased bonding strength causes the resulting bonded portion to crack due to repeated thermal fatigue. As a result, heat dissipation from a semiconductor is impeded, and the performance of the chip is deteriorated. The present invention provides a solder pellet for die bonding which has extremely suppressed formation of voids during die bonding in spite of using lead-free solder which has inferior wettability. The invention also provides an electronic component having minimized voids.

### Means for Solving the Problem

The present inventors discovered that forming a colorless transparent protective film made of Sn, O, and P or a colorless transparent protective film made of Sn, In, O, and P on the surface of a lead-free solder comprising predominantly Sn (containing Sn as a main component) prevents the formation of an oxide film of SnO₂ or In₂O₃ ranging in appearance from an intensive yellow to brown on the solder surface when the solder is heated and that the protective film is easily pulverized by heating so that the inherent fluidity and reactivity of molten solder are improved, and they thereby completed the present invention.

The present invention is a solder pellet for use in die bonding to join a semiconductor chip and a substrate to each other in an electronic component, the solder pellet being made of a lead-free solder alloy containing Sn as its major constituent and forming a colorless transparent protective film which consists essentially of 30 - 50 atomic % of O, 5 - 15 atomic % of P, and a remainder of Sn or which consists essentially of 10 - 30 atomic % of In, 40 - 60 atomic % of O, 5 - 15 atomic % of P, and a remainder of Sn on the surface of the solder during heating for soldering. The thickness of the protective film is preferably 0.5 - 20 nm and more preferably 1 - 5 nm. In addition, the present invention is a soldering method using a solder pellet for die bonding to bond a semiconductor chip and a substrate in an electronic component to each other, wherein the pellet forms a colorless transparent protective film having a thickness of 0.5 - 20 nm and comprising 30 - 50 atomic % of O, 5 - 15 atomic % of P, and a remainder essentially of Sn on the surface of a lead-free solder alloy comprising predominantly Sn when heated for soldering.

Another aspect of the present invention is an electronic component comprising a semiconductor chip and a substrate which are bonded to each other by die bonding with a solder pellet for die bonding to join a semiconductor chip and a substrate, the solder pellet having a colorless transparent protective film which comprises 30 - 50 atomic % O, 5 - 15 atomic % P, and a remainder essentially of Sn or which comprises 10 - 30 atomic % In, 40 - 60 atomic % O, 5 - 15 atomic % P, and a remainder essentially of Sn formed on the surface of a lead-free solder alloy comprising predominantly Sn during heating for soldering, the pellet providing a void percentage of at most 10% in the bond area formed by die bonding.

### Effects of the Invention

A solder pellet for die bonding according to the present invention is formed using a lead-free solder. Therefore, if broken electronic equipment is disposed of outside or in the ground, leaching of lead caused by acid rain does not occur, thus preventing environmental pollution resulting from such leaching. In addition, in spite of use of a lead-free solder which inherently has inferior wettability, a solder pellet according to the present invention has excellent wettability, which results in little formation of voids. An electronic component according to the present invention has few voids between a semiconductor chip and a substrate, so it has excellent reliability in that a sufficient bonding strength is obtained.

### Best Mode for Carrying Out the Invention

The lead-free solder used in the present invention is 100% Sn or an alloy comprising predominantly Sn. Thus, Sn by itself can be used as a lead-free solder, or Sn can be used with additional element or elements added thereto. A suitable lead-free solder for use in the present invention is any of a Sn based alloy, a Sn-Cu based alloy, a Sn-Ag based alloy, a Sn-Ag-Cu based alloy, a Sn-Bi based alloy, and a Sn-In based alloy. The term "based" used herein means that the above-described additional element or elements may suitably be added to the indicated main elements. For example, a Sn-Ag based alloy includes not only a Sn-Ag alloy itself, but also an alloy in which one or more additional elements are suitably added to this alloy.

In order to form a colorless transparent protective film which comprises 30 - 50 atomic % O, 5 - 15 atomic % P, and a remainder essentially of Sn or which comprises 10 - 30 atomic % In, 40 - 60 atomic % O, 5 - 15 atomic % P, and a remainder essentially of Sn on a lead-free solder used in a solder pellet for die bonding according to the present invention, it is necessary to previously add 0.0001 - 0.02 mass % of P to the solder alloy. If the amount of P which is added is less than 0.0001 mass %, it is difficult to form such a protective film and it is difficult to suppress the formation of a yellow SnO₂ film. On the other hand, if P is added in excess of 0.02 mass %, the liquidus temperature of the solder itself rises and its wettability decreases. In addition, coarse crystals of a Sn-P compound are precipitated inside the solder structure, thereby worsening the mechanical properties of the solder.

If a solder pellet for die bonding according to the present invention has a thickness smaller than 0.05 mm, the amount of solder present in an area for bonding between a semiconductor chip and a substrate is too small, and not only does the bonding strength become insufficient, but it also becomes easy for voids to form. On the other hand, if the thickness of a pellet exceeds 1 mm, the amount of solder becomes too large, and the excess solder protrudes from the semiconductor chip after solder bonding, thereby causing the excess solder to adhere to unnecessary locations or to contact wires during subsequent wire bonding.

A solder pellet for die bonding according to the present invention has a shape which is generally the same as that of a semiconductor chip which is to be bonded. If the solder pellet is too much smaller than the semiconductor chip, solder does not spread over the entirety of the semiconductor chip and the formation of voids increase, so the bonding strength weakens. On the other hand, if the pellet is too much larger than the semiconductor chip, there is no restraining force acting on the top surface of a portion of the solder pellet which protrudes beyond the chip, and due to surface tension, the protruding solder becomes spherical after soldering, which causes the amount of solder beneath the chip to decrease. As a result, not only does the bonding reliability in thermal fatigue decrease, but the solder which protrudes from the chip adheres to unnecessary locations and causes short circuits.

An electronic component according to the present invention is one in which a semiconductor chip and a substrate are die bonded by an alloy to which 1 - 200 ppm of P is added. The proportion of area occupied by voids in the bond area (the void percentage) is at most 10%. In general, if the void percentage in the bond area between a semiconductor chip and a substrate is large, in order to increase thermal conductivity and bonding strength, it is necessary to greatly modify the design by increasing the solder thickness, lowering the thermal expansion of the substrate, or the like, and this is contrary to modem-day fine pitch mounting. In addition, the bonding strength becomes weak, and when the entire substrate undergoes repeated expansion and contraction due to electrical heat generated during use of a product, cracks develop in the bond area due to repeated thermal fatigue, thereby impeding heat dissipation from the semiconductor chip and deteriorating the performance of the chip. Therefore, in the present invention, the void percentage is made at most 10%.

### Example 1

A semiconductor chip measuring 10 x 10 x 0.3 (mm) was bonded to a substrate (nickel-plated copper substrate) measuring 30 x 30 x 0.3 (mm) by die bonding with a solder pellet. As shown in Table 1, the lead-free solder which was used was a Sn-Cu-Ni based solder to which P was added. The solder pellet, which was formed from the solder to a shape of 10 x 10 x 0.1 (mm), was sandwiched between the semiconductor chip and the substrate and heated in a reflow furnace in a mixed hydrogen-nitrogen gas atmosphere with an oxygen concentration of 50 ppm for an overall duration of reflow heating of 15 minutes in which the temperature was 235° C or higher for 3 minutes with a peak temperature of 280° C. The thickness of a protective film which formed on the surface of the solder and the metal composition thereof were measured by XPS. Voids were observed in the portion which was die bonded with a transmission X-ray apparatus to determine the void percentage.

### Example 2

A semiconductor chip measuring 10 x 10 x 0.3 (mm) was bonded to a substrate (nickel-plated copper substrate) measuring 30 x 30 x 0.3 (mm) by die bonding with a solder pellet. As shown in Table 1, the lead-free solder which was used was a Sn-Ag-Cu based solder to which P was added. The solder pellet, which was formed to a shape of 10 x 10 x 0.1 (mm), was sandwiched between the semiconductor chip and the substrate and heated in a reflow furnace in a mixed hydrogen-nitrogen gas atmosphere with an oxygen concentration of 50 ppm for an overall duration of reflow heating of 15 minutes in which the temperature was 235° C or higher for 3 minutes with a peak temperature of 280° C. The thickness of a protective film which formed on the surface of the solder and the metal composition thereof were measured by XPS. Voids were observed in the portion which was die bonded with a transmission X-ray apparatus to determine the void percentage.

### Example 3

A semiconductor chip measuring 10 x 10 x 0.3 (mm) was bonded to a substrate (nickel-plated copper substrate) measuring 30 x 30 x 0.3 (mm) by die bonding with a solder pellet. As shown in Table 1, the lead-free solder which was used was a Sn-In based solder to which P was added. The solder pellet, which was formed to a shape of 10 x 10 x 0.1 (mm), was sandwiched between the semiconductor chip and the substrate and heated in a reflow furnace in a mixed hydrogen-nitrogen gas atmosphere with an oxygen concentration of 50 ppm for an overall duration of reflow heating of 15 minutes in which the temperature was 235° C or higher for 3 minutes with a peak temperature of 280° C. The thickness of a protective film which formed on the surface of the solder and the metal composition thereof were measured by XPS. Voids were observed in the portion which was die bonded with a transmission X-ray apparatus to determine the void percentage.

The composition of the solder pellet in each of Examples 1 - 3, as well as the results of measurement of the thickness, metal composition, and void percentage of the protective film formed on the surface of the solder are shown in Tables 1 - 3.

The thickness and the metal composition of the protective film were measured by XPS, which was performed while the surface was removed by repeated sputtering to a depth of 0.2 nm each time in order to collect data in the thickness direction. The void percentage was measured using an X-ray transmission type microscope capable of cross-sectional observation at a magnification of 50 times.

**Table 1**

| | Composition (wt %) | | | | Protective film composition (at. %) | | | Protective film thickness (nm) | Void percentage (%) |
|---|---|---|---|---|---|---|---|---|---|
| | Sn | Cu | Ni | P (ppm) | Sn | O | P | | |
| Run 1 | rem. | 0.7 | 0.06 | 10 | 48 | 44 | 8 | 1 | 7.0 |
| Run 2 | rem. | 0.7 | 0.06 | 50 | 44 | 45 | 11 | 12 | 3.5 |
| Run 3 | rem. | 0.7 | 0.06 | 200 | 51 | 35 | 14 | 8 | 4.2 |
| Comp. Run 1 | rem. | 0.7 | 0.06 | 0 | 40 | 60 | 0 | 0 | 13.0 |
| Comp. Run 2 | rem. | 0.7 | 0.06 | 400 | 50 | 36 | 14 | 18 | 15.0 |

**Table 2**

| | Composition (wt %) | | | | Protective film composition (at. %) | | | Protective film thickness (µm) | Void percentage (%) |
|---|---|---|---|---|---|---|---|---|---|
| | Sn | Cu | Ag | P (ppm) | Sn | O | P | | |
| Run 1 | rem. | 0.5 | 3 | 10 | 44 | 47 | 9 | 2 | 8.0 |
| Run 2 | rem. | 0.5 | 3 | 50 | 44 | 49 | 7 | 12 | 5.8 |
| Run 3 | rem. | 0.5 | 3 | 150 | 46 | 43 | 11 | 8 | 6.2 |
| Comp. Run 1 | rem. | 0.5 | 3 | 0 | 33 | 67 | 0 | 0 | 17.0 |
| Comp. Run 2 | rem. | 0.5 | 3 | 400 | 50 | 36 | 14 | 18 | 13.0 |

**Table 3**

| | Composition (wt %) | | | Protective film composition (at. %) | | | | Protective film thickness (µm) | void percentage (%) |
|---|---|---|---|---|---|---|---|---|---|
| | Sn | In | P (ppm) | Sn | O | In | P | | |
| Run 1 | rem. | 15 | 10 | 12 | 50 | 25 | 13 | 2 | 8.0 |
| Run 2 | rem. | 15 | 50 | 10 | 55 | 20 | 15 | 11 | 7.0 |
| Run 3 | rem. | 15 | 150 | 14 | 56 | 22 | 8 | 16 | 6.5 |
| Comp. Run 1 | rem. | 15 | 0 | 15 | 60 | 25 | 0 | 0 | 25.0 |
| Comp. Run 2 | rem. | 15 | 250 | 15 | 45 | 24 | 16 | 15 | 18.0 |

As is clear from Tables 1 - 3, electronic components which were die bonded using a solder in which P was added to a lead-free solder had a void percentage which was at least 40% smaller than that of a solder having the same composition to which P was not added. In addition, when die bonding was carried out with a solder to which P was added, the void percentage was at most 10%, but when die bonding was carried out with a solder to which P was not added, the void percentage exceeded 10%.

### Industrial Applicability

When manufacturing an electronic component according to the present invention, the optimal bonding method to reduce voids is die bonding performed in a mixed hydrogen-nitrogen. However, a mixed hydrogen-nitrogen gas is expensive, and it is possible to use other bonding methods. When carrying out die bonding in air without using a mixed hydrogen-nitrogen gas to reduce costs, it is necessary to use flux, but a solder pellet for die bonding according to the present invention can reduce voids even if flux is used. In addition, an electronic component according to the present invention can be manufactured using a solder paste. Solder paste is a mixture of solder powder and flux, which makes it unnecessary to separately supply flux, so bonding can be carried out in a rational manner.

## Claims

1. A soldering method using a solder pellet for die bonding to bond a semiconductor chip and a substrate to each other in an electronic component, the pellet forming a colorless transparent protective film having a thickness of 0.5 - 20 nm and comprising 30 - 50 atomic % of O, 5 - 15 atomic % of P, and a remainder essentially of Sn on the surface of a lead-free solder alloy comprising Sn as a main constituent when heated for soldering.

2. A solder pellet for die bonding to join a semiconductor chip and a substrate of an electronic component to each other, **characterized in that** the pellet forms a colorless transparent protective film having a thickness of 0.5 - 20 nm and comprising 30 - 50 atomic % of O, 5 - 15 atomic % of P, and a remainder essentially of Sn on the surface of a lead-free solder alloy comprising Sn as a main constituent when heated for soldering, the pellet having generally the same shape as the semiconductor chip to be joined to the substrate.

3. A solder pellet for die bonding as set forth in claim 2 **characterized in that** the solder pellet for die bonding has a thickness of 0.05 - 1 mm.

4. A solder pellet for die bonding as set forth in claim 2 or claim 3 **characterized in that** the lead-free solder alloy comprising Sn as a main constituent is any one selected from a Sn based alloy, a Sn-Cu based alloy, a Sn-Ag based alloy, a Sn-Ag-Cu based alloy, a Sn-Bi based alloy, and a Sn-Pb based alloy.

5. A solder pellet for die bonding to join a semiconductor chip and a substrate of an electronic component to each other, **characterized in that** the pellet forms a colorless transparent protective film having a thickness of 0.5 - 20 nm and comprising 10 - 30 atomic % of In, 40 - 60 atomic % of O, 5 - 15 atomic % of P, and a remainder essentially of Sn on the surface of a lead-free solder alloy comprising Sn as a main constituent when heated for soldering, the pellet having generally the same shape as the semiconductor chip to be joined to the substrate.

6. A solder pellet for die bonding as set forth in claim 5 **characterized in that** the solder pellet for die bonding has a thickness of 0.05 - 1 mm.

7. A solder pellet for die bonding as set forth in claim 5 or 6 **characterized in that** the lead-free solder alloy comprising Sn as a main constituent is either a Sn-In based alloy or a Sn-Bi-In based alloy.

8. A method of manufacturing a solder pellet for die bonding as set forth in any of claims 2 - 4 **characterized by** forming a solder alloy comprising 0.3 - 1.0 mass % of Cu, 0.01 - 0.1 mass % ofNi, 0.0001 - 0.02 mass % ofP, and a remainder essentially of Sn into the shape of a pellet, and heating it for 3 minutes at a temperature of 235° C or above with a peak temperature of 280° C in a hydrogen-nitrogen atmosphere with an oxygen concentration of at most 50 ppm to form a protective film.

9. A method of manufacturing a solder pellet for die bonding as set forth in any of claims 2 - 4 **characterized by** forming a solder alloy comprising 3.0 - 4.0 mass % of Ag, 0.3 - 1.0 mass % of Cu, 0.01 - 0.1 mass % ofNi, 0.0001 - 0.02 mass % of P, and a remainder essentially of Sn into the shape of a pellet, and heating it for 3 minutes at a temperature of 235° C or above with a peak temperature of 280° C in a hydrogen-nitrogen atmosphere with an oxygen concentration of at most 50 ppm to form a protective film.

10. A method of manufacturing a solder pellet for die bonding as set forth in any of claims 5 - 7 **characterized by** forming a solder alloy comprising 0.2 - 2.0 mass % of In, 0.0001 - 0.02 mass % of P, and a remainder essentially of Sn into the shape of a pellet, then heating it for 3 minutes at a temperature of 235° C or above with a peak temperature of 280° C in a hydrogen-nitrogen atmosphere having an oxygen concentration of at most 50 ppm to form a protective film.

11. An electronic component comprising a semiconductor chip and a substrate bonded to each other by die bonding with a lead-free solder alloy comprising Sn as a main constituent, **characterized in that** the solder alloy forms a colorless transparent protective film comprising 30 - 50 atomic % of O, 5 - 15 atomic % of P, and a remainder essentially of Sn or 10 - 30 atomic % of In, 40 - 60 atomic % of O, 5 - 15 atomic % of P, and a remainder essentially of Sn on the surface of the alloy when heated for soldering, the void percentage in the bond area being at most 10%.
